# EUROPEAN PATENT SPECIFICATION

(11) **EP 4 320 450 B1**
(45) Date of publication and mention of the grant of the patent: **11.06.2025**
(21) Application number: 21717441.6
(22) Date of filing: 08.04.2021
(51) Int. Cl.: G01R 19/165, G01R 21/00, G01R 31/40

(54) **HOUSEHOLD APPLIANCE AND OPERATING METHOD THEREOF**
HAUSHALTSGERÄT UND BETRIEBSVERFAHREN DAFÜR
APPAREIL ÉLECTROMÉNAGER ET SON PROCÉDÉ DE FONCTIONNEMENT

(43) Date of publication of application: 14.02.2024
(73) Proprietor: ELECTROLUX APPLIANCES AKTIEBOLAG, 105 45 Stockholm (SE)
(72) Inventor: RIZZO, Luca, 33080 Porcia (IT)
(74) Representative: Electrolux Group Patents
(86) International application number: PCT/EP2021/059222
(87) International publication number: WO 2022/214186

(56) References cited:
- WO-A1-2018/177806
- WO-A1-2020/224303
- CN-U- 203 365 525

## Description

The present invention relates to a household appliance and an operating method thereof.

More specifically, the present invention concerns the real-time measurement of the electric power supplied to a household appliance, to which the following description will makes explicit reference without however losing in generality.

### BACKGROUND ART

It is known the need to monitor the electric power, and in particular, both the voltage and the current supplied to a household appliance from the external public power supply grids in order to detect critical electric conditions generated in the public grids themselves.

In fact, it may happen that an overvoltage condition generated in the public power supply grid causes, on the one hand, damage to electronic circuits or devices of the household appliance, and on the other hand a potentially dangerous condition for users.

In recent years, the frequency of the aforementioned critical conditions of sudden overvoltage has increased especially in some countries wherein domestic and industrial users in adjacent areas, are locally connected to the same power distribution point/cabin.

It often happens that a request for an increase of energy by industrial users determines an electric power peak in the electric power distribution point which exposes the household appliances of domestic users to electric critical conditions, such as over-voltages.

Moreover, it may happen that connection errors on the electric lines e/o on electric power distribution point during maintenance operations may cause accidental over-voltages on the grid, damaging the electronic circuits of the refrigerators.

Aim of the present invention is therefore, on the one side, to overcome the technical problems referred above, and on the other sides to satisfy the need to monitor in real time the electric power that household appliances receive from a public power supply grid.

WO 2020/224303 A1 discloses an air conditioner overvoltage detection circuit.

CN 203 365 525 U discloses a power grid voltage detection device.

WO 2018/177806 A1 discloses separation of a domestic appliance from a supply network.

According to independent claim 1 the invention provides a household appliance comprising: first power supply lines which are connectable to an AC power supply source for receiving a main electric power from said AC power supply source and for providing a first AC voltage and a first AC current, at least a first load, at least a second load operating by a second voltage lower than said first AC voltage, a master control circuit operating by said second voltage, which is configured to generate control signals to selectively control said first load and second load, and comprises a current measuring sensor configured to measure said first AC current and provide a first value indicative of said first AC current, an inverter device which is electrically connected to said first power supply lines for receiving said first AC voltage and to said master electronic control circuit to receive said control signal, and is configured to control the voltage supplied to said first load based on said control signal, said inverter device further comprises a voltage measurement circuit configured to measure said first AC voltage and provide a second value indicative of said first AC voltage; the inverter device is configured to provide said second value to said master control circuit by opto-isolator electronic means, said master control circuit is configured to determine a third value indicative of said main electric power based on said first value and second value.

The Applicant has found that connecting the master control circuit to the inverter device via the opto-isolator module allows to maintain electrically safe the master control circuit and in particular the loads. The technical effect obtained by using the opto-isolator module to connect the master control circuit to the inverter device is, on the one hand, to electrically isolate the electric loads from the main power lines having the first AC voltage potentially dangerous for users, and, on the other hand, using the measurement circuit comprised in the inverter device.

Indeed, arranging a voltage measurement circuit in the master control circuit would increase the complexity and cost of the electronic control system. The electric insulation of the voltage measurement circuit in the master control circuit would increase the overall cost of the system, without guarantying completely the electric isolation of the low voltage loads from the first AC voltage. It is highlighted that loads, in use, are exposed to the risk of contact with users. Consequently, it is necessary to ensure that loads be powered by the low voltage. The use of the voltage measure circuit in the master control circuit, instead of the inverter device, could determine, in the event of a malfunction, the directly supply of the first voltage to the low voltage loads, causing a dangerous condition for users and loads. On the contrary, using the voltage measurement circuit of the inverter device in combination with the galvanic separation made by the opto-isolator module between the inverter device and the master control circuit as envisaged by the present invention, ensures a complete electric isolation of the latter and the loads from the inverter device.

Preferably, said master control circuit is further configured to provide said control signal to said inverter device by said opto-isolator electronic means.

Preferably, said opto-isolator electronic means are comprised in said inverter device.

Preferably, said opto-isolator electronic means are comprised in said master control circuit.

Preferably, said opto-isolator electronic means are structured to maintain said master control circuit and said inverter device galvanically insulated from each other.

Preferably, the household appliance further comprises a voltage transformer module which comprises input terminals connected to said power supply lines, and output terminals connected to said master control circuit, said voltage transformer module being configured to transform said first AC voltage in said second voltage to be supplied to said master control circuit and or to said second loads and is structured to maintain electrically isolated said master control circuit and/or said second loads from said power supply lines.

Preferably, said current measuring sensor comprises a Hall Effect sensor.

Preferably, said master control circuit is configured to determine in real-time said main electric power based on said first value and second value.

Preferably, said master control circuit is configured to determine an overvoltage supply condition of said first power supply lines based on said second value.

Preferably, said master control circuit is configured to determine an anomalous operation condition or a malfunction condition of said first loads and/or second loads based on said main electric power.

Preferably, said household appliance is a refrigerator appliance and said first load comprises at least one among: a compressor unit, and a defrost heating resistor, and said second load comprises at least one among: a control panel and a illuminating circuit.

Preferably, said household appliance is a laundry washing machine and said first load comprises at least one among: a drain pump, a recirculation pump a drum motor circuit and a heating resistor, said second load comprises at least one among: a control panel and a illuminating circuit.

Preferably, said appliance is an oven and said first load comprises at least one among: a heating resistor, a fan motor a microwave generator unit, said second load comprises at least one among: a control panel and a illuminating circuit.

Preferably, said appliance is a laundry dryer machine and said first load comprises at least one among: heating resistor, drum motor circuit, compressor unit, a motor fan, said second load comprises at least one among: a control panel and a illuminating circuit.

According to independent claim 15, the invention further concerns a method of operating of a household appliance, the household appliance comprising: first power supply lines which are connectable to an AC power supply source for receiving a main electric power from said AC power supply source and for providing a first AC voltage and a first AC current, at least a first load, at least a second load operating by a second voltage lower than said first AC voltage, a master control circuit operating by said second voltage, which is configured to generate control signals to selectively control said first load and second load, an inverter device, which is electrically connected to said first power supply lines for receiving said first AC voltage and said first AC current and to said master control circuit to receive said control signal, and is configured to control the voltage supplied to said first load based on said control signal; the method comprises the steps of : measuring by a current sensor of the master control circuit a first AC current and providing a first value indicative of said first AC current, measuring by a voltage measurement circuit of said inverter device said first AC voltage and providing a second value indicative of said first AC voltage, providing said second value from said inverter device to said master control circuit by opto-isolator electronic means, determining by said master control circuit said main electric power based on said first and second value.

As described above, the combined use of the voltage measure circuit of the inverter device to measure the first AC voltage and the galvanic separation between the inverter device and the master control circuit made by the opto-isolator module allows, on the one hand, to reduce the cost of the electronic system, and on the other hand, reducing the risk that the low voltage loads can be affected by the dangerous first AC voltage V1.

Preferably, said master control circuit is further configured to provide said control signal to said inverter device by said opto-isolator electronic means.

Preferably, said opto-isolator electronic means are comprised in said inverter device.

Preferably, said opto-isolator electronic means are comprised in said master control circuit.

Preferably, said opto-isolator electronic means are structured to maintain said master control circuit and said inverter device galvanically insulated from each other.

Preferably, the household appliance further comprises a voltage transformer module which comprises input terminals connected to said power supply lines, and output terminals connected to said master control circuit, said voltage transformer module being configured to transform said first AC voltage in said second voltage to be supplied to said master control circuit and or to said second loads and is structured to maintain electrically isolated said master control circuit and/or said second loads from said power supply lines.

Preferably, said current measuring sensor comprises a Hall Effect sensor.

Preferably, said master control circuit is configured to determine in real-time said main electric power based on said first value and second value.

Preferably, said master control circuit is configured to determine an overvoltage supply condition of said first power supply lines based on said second value.

Preferably, said master control circuit is configured to determine an anomalous operation condition or a malfunction condition of said first loads and/or second loads based on said main electric power.

Preferably, said household appliance is a refrigerator appliance and said first load comprises at least one among: a compressor unit, and a defrost heating resistor, and said second load comprises at least one among: a control panel and a illuminating circuit.

Preferably, said household appliance is a laundry washing machine and said first load comprises at least one among: a drain pump, a recirculation pump a drum motor circuit and a heating resistor, said second load comprises at least one among: a control panel and a illuminating circuit.

Preferably, said appliance is an oven and said first load comprises at least one among: a heating resistor, a fan motor a microwave generator unit, said second load comprises at least one among: a control panel and a illuminating circuit.

Preferably said appliance is a laundry dryer machine and said first load comprises at least one among: heating resistor, drum motor circuit, compressor unit, a motor fan, said second load comprises at least one among: a control panel and a illuminating circuit.

### BRIEF DESCRIPTION OF THE DRAWINGS

Further characteristics and advantages of the present invention will be highlighted in greater detail in the following detailed description of some of its preferred embodiments, provided with reference to the enclosed drawings. The nvention is defined by the independent claims, advantageous embodiments are provided by the dependent claims.

An embodiment of the present invention will now be described, by way of example, with reference to the accompanying drawings, in which:
- Figure 1 is a schematic view illustrating a household appliance with a schematized electronic control system, realized in accordance with the teachings of the present invention;
- Figure 2 is a block diagram of the electronic control system of the household appliance shown in Figure 1.

### DETAILED DESCRIPTION OF THE INVENTION

The present invention has proved to be particularly advantageous when applied to household appliance corresponding to a refrigerator appliance designed to be supplied with AC voltage and provided with an electronic system configured to determine conveniently in real-time the electric power absorbed by the refrigerator appliance itself (i.e. the overall power consumption of the refrigerator appliance).

However, it should in any case be underlined that the present invention is not limited to a refrigerator appliance. Indeed, the present invention can be conveniently applied to other kind of household appliances (domestic appliances), like for example laundry washing machines, drying machines and ovens.

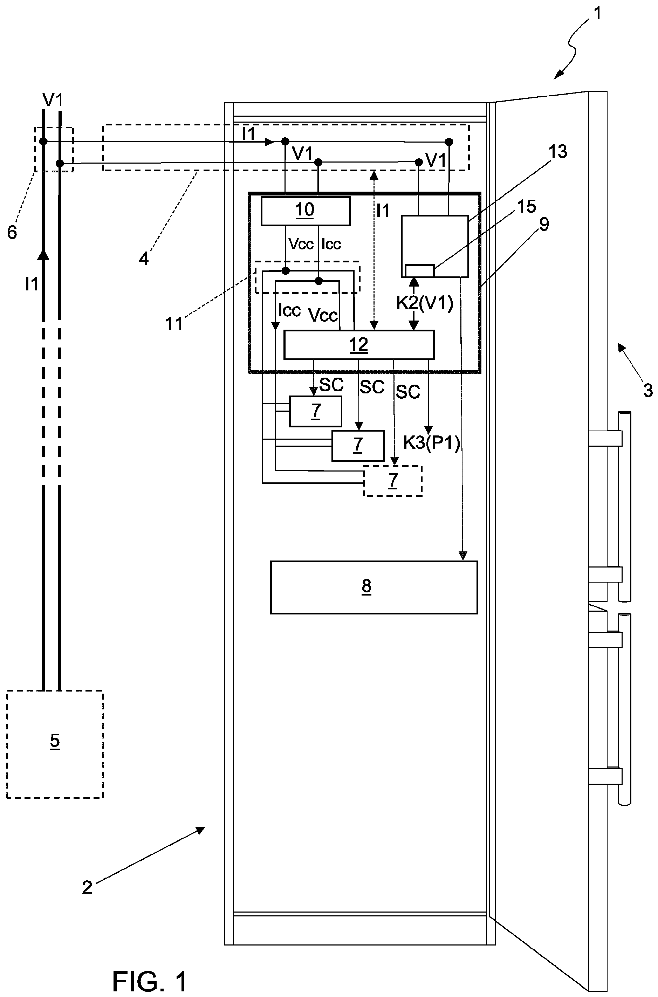

With reference to Figure 1, reference number 1 denotes as a whole a household electric appliance corresponding to a refrigerator appliance. The refrigerator appliance 1 is adapted for preserving perishable foodstuff and preferably suitable for domestic use, i.e. a household refrigerator.

Refrigerator appliance 1 comprises a preferably substantially parallelepiped-shaped, self-supporting cabinet 2, which has a thermal-insulating structure and is internally provided with at least one, preferably substantially parallelepiped-shaped, thermal-insulated storage cavity which is adapted to accommodate food-stuff and communicates with the outside via a large, preferably roughly rectangular-shaped, access opening which is located on a main face/wall of the same cabinet 2.

The refrigerator appliance 1 further comprises at least one door 3 (two doors in the illustrated example in Figure 1) that has a thermal-insulating structure and is flag hinged to the cabinet 2, so as to be manually rotatable to and from a closing position in which the door abuts on said main face/wall of the cabinet 2 to substantially airtight close/seal the access opening of said storage cavity. In the example shown, in particular, the self-supporting cabinet 2 is preferably structured for stably resting on the floor/ground.

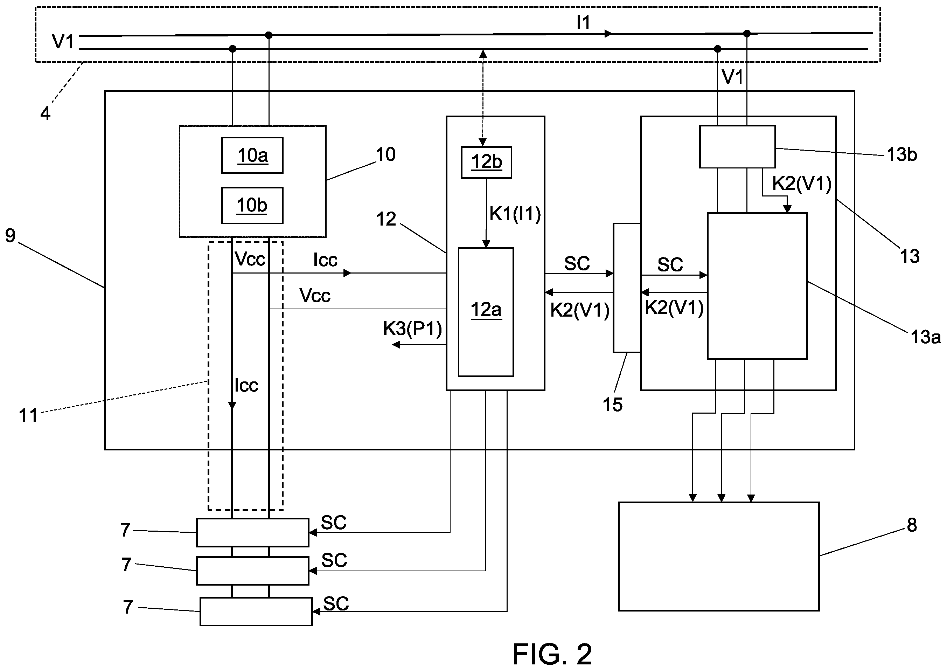

With reference to Figures 1 and 2, the refrigerator appliance 1 further comprises power supply lines 4 which are connectable to an AC power supply source 5 for receiving a main electric power from the AC power supply source 5 and for providing a first AC voltage V1 and a first AC current I1. In the exemplary embodiment of Figure 2 the power supply lines 3 are electrically coupled to a power socket 6, e.g. by means of an AC power cord (not illustrated), for receiving electric power from an AC power supply source 5.

The power supply lines 4 preferably comprise a first and second power lines having the first AC voltage V1 from each other (line and neutral). The first AC voltage V1 between the first and second lines may oscillates, for example at a frequency of 50 or 60 Hz, causing the first AC current I1 to flow across a generic electric load when connected between lines. The first AC voltage may be for example about 127 Volt or 220 Volt.

It is understood that in the present document, the term AC power source 5, means any known means/structures/units/apparatuses for generating and/or transforming, and/or delivering, and/or converting AC electric power (wherein AC is the acronym of Alternating Current). In the example shown in FIG. 1, the electric power supplied by the AC power source 5 is provided to the refrigerator appliance 1 by the power socket 6 (schematically illustrated in Figures 1 and 2).

It is understood that the AC power supply source 5 may be an interconnected network (electric grid) for delivering electricity from suppliers to consumers, which comprises, for example, public available AC power supplies, that produce electric power, preferably high-voltage transmission grids comprising high-voltage transmission lines for carrying power from the (typically distant) public available AC power supplies to demand centers, and, preferably, medium-voltage distribution grids for connecting individual customers, such as the building wherein the power socket 6 is located.

According to the exemplary embodiment illustrated in Figure 1, the household appliance 1 comprises one or more electric loads 7 and one or more electric loads 8.

With reference to Figures 1 and 2, in the example shown, the electric loads 8 may comprise: a compressor unit for the circulating refrigerant and/or a heating resistor for performing defrost cycles.

With reference to Figures 1 and 2, in the example shown, the electric loads 7 may comprise: a control panel and/or an illuminating circuit provided with light sources, for example LED-sourced arranged inside thermal-insulated storage cavity.

According to the exemplary embodiment illustrated in Figure 1, the refrigerator appliance 1 comprises an electronic control system 9, which is configured to selectively control the electric loads 7 and the electric loads 8 based on the implemented refrigerating program.

The electronic control system 9 may comprise a voltage conversion circuit 10 which is electrically connected by input terminals with the power supply lines 4 for receiving the first AC voltage V1 and the first AC current I1 and is electrically connected by output terminals with second supply lines 11 to provide a second voltage Vcc and a second current Icc.

According to an exemplary embodiment the voltage conversion circuit 10 is configured to transform, rectify and regulate the first AC voltage V1 received from power supply lines 4 (line and neutral) and provides the second voltage Vcc and second current Icc to the second supply lines 11. The second voltage is lower than said first AC voltage. The second voltage is a low voltage preferably a DC Voltage having a value among: 3V, 5V or 12V (DC voltage) with respect to a prefixed reference voltage, for example a ground voltage.

The voltage conversion circuit 10 may comprise for example: a voltage magnetic transformer 10a having the primary circuit electrically connected to the power supply lines 4 for receiving the first AC voltage and a secondary circuit providing a reduced AC voltage. The voltage conversion circuit 10 may further comprise a AC/DC rectifying and regulating unit 10b which comprise input terminals electrically connected to the secondary circuit of the voltage magnetic transformer 10a for receiving the reduced AC voltage and output terminals electrically connected to second supply lines 11 to provide to the latter the second voltage Vcc and second current Icc.

The electronic control system 9 further comprises a master control circuit 12 and an inverter device 13. The master control circuit 12 is designed to supervise and manage the operations performed by the refrigerator appliance. In the exemplary embodiment of the present invention, the master control circuit 12 is configured to generate control signals SC to selectively control the electric loads 7 and the electric load 8.

According to the preferred embodiment of the present invention, the master control circuit 12 is electrically connected with the second supply lines 11 for being supplied by the second voltage Vcc and with the electric loads 7 to provide the latter with the respective control signals SC.

The master control circuit 12 may comprise an electronic processing unit 12a, i.e. a microprocessor, configured to generate the control signals SC to be used to control the electric loads 7 and 8. The master control circuit 12 comprises a current sensor 12b. The current sensor 12b is configured to measure the first AC current I1, which crosses the power supply lines 4. The current sensor 12b is configured to provide to the electronic processing unit 12a a first value K1(I1), which is indicative of the first AC current I1, measured on the power supply lines 4. Conveniently, the current sensor 12b is a Hall Effect sensor. The Hall Effect sensor is configured to sense the magnetic field generated by the passage of the first AC current I1 across the power supply lines 4. The Hall Effect sensor is configured to provide a corresponding electric signal containing the first value K1(I1). The first value K1(I1) may corresponds, for example, to a voltage proportional to the sensed magnetic field depending on the first AC current I1. The current sensor 12b may conveniently correspond to the current sensor described in the European invention patent application n. EP3542433A1.

With reference to Figures 1 and 2, the inverter device 13 is electrically connected to the power supply lines 4 for receiving the first AC voltage V1 and first AC current I1 and is configured to drive the electric load 8. The inverter device 13 is further configured to receive in input the control signal SC and controls the AC voltage and AC current supplied to the electric load 8 based on the received control signal SC.

The inverter device 13 comprises a processing circuit 13a, i.e. a microprocessor, which supervises and manages the operations to control the voltage and current supplied to the electric load 8, based on the control signals.

The inverter device 13 further comprises a voltage measurement circuit 13b configured to measure the first AC voltage on the power supply lines 4. The voltage measurement circuit 13b is configured to provide a second value K2(V1) indicative of the measured first AC voltage V1. The voltage measurement circuit 13b is electrically connected with the processing circuit 13a and provides to the latter an electric signal containing the second value K2(V1).

According to a preferred embodiment of the present invention, the electronic control system 9 further comprise a opto-isolator module 15 which connects the inverter device 13 with the master control circuit 12 to which provides the second value K2(V1).

According to an exemplary embodiment illustrated in Figures 1 and 2, the opto-isolator module 15 is electrically arranged/integrated in the inverter device 13 and comprise terminals electrically connected to the processing circuit 13a and terminals electrically connected to the electronic processing unit 12a by means of connection lines (electric wires).

The opto-isolator module 15 is configured to receive the electric signals containing the second value K2(V1) from the processing circuit 13a, transform the electric signals in light signals, convert the transformed light signals in the electric signals, and provide the electric signals to the electronic processing unit 12a. The opto-isolator module 15 is also is configured to receive the electric signals containing the control signal SC from the electronic processing unit 12a transform the electric signals in light signals, convert the transformed light signals in the electric signals, and provide the electric signals to the processing circuit 13a. In other words, the opto-isolator module 15 may be conveniently bidirectional.

According to the preferred embodiment of the present invention, the electronic processing unit 12a of the master control circuit 12 is further configured to receive the first value K1(I1) from the current sensor 12b and receive the second value K2(V1) from the inverter device 13 via the terminal connected to the opto-isolator module 15.

According to the preferred embodiment of the present invention, the electronic processing unit 12a of the master control circuit 12 is further configured to determine a third value K3(P1) indicative of the main electric power based on the first K1(I1) and second value K2(V1). According to the preferred embodiment of the present invention, the electronic processing unit 12a of the master control circuit 12 is configured to determine the first AC current I1 based on the first value K1(I1), determine the first AC voltage V1 based on the second value K2(V1) and determine the power P1 multiplying the first AC current I1 by the first AC voltage V1.

According to the preferred embodiment of the present invention, the electronic processing unit 12a of the master control circuit 12 is further configured to determine the third value indicative of the main electric power in real-time.

Preferably, the electronic processing unit 12a may be configured to determine, based on the first and second value, the following values: the real power, and/or the apparent power, and or the reactive power, and/or the power factor.

The Applicant has found that connecting the master control circuit 12 to the inverter device 13 via the opto-isolator module 15 allows to maintain electrically safe the master control circuit 12 and in particular the loads 7.

The technical effect obtained by using the opto-isolator module 15 to connect the master control circuit 12 to the inverter device 13 is, on the one hand, to electrically isolate the electric loads 7 from the main power lines 4 having the first AC voltage V1 potentially dangerous for users, and, on the other hand, using the measurement circuit 13a comprised in the inverter device 13.

Indeed, arranging a voltage measurement circuit in the master control circuit 12 would increase the complexity and cost of the electronic control system 19. The electric insulation of the voltage measurement circuit in the master control circuit 12 would increase the overall cost of the system, without guarantying completely the electric isolation of the low voltage loads 7 from the first AC voltage V1.

It is highlighted that loads 7, in use, are exposed to the risk of contact with users. Consequently, it is necessary to ensure that loads 7 be powered by the low voltage. The use of the voltage measure circuit in the master control circuit 12, instead of the inverter device 13, could determine, in the event of a malfunction, the directly supply of the first voltage to the low voltage loads 7, causing a dangerous condition for users and loads 7. On the contrary, using the voltage measurement circuit 13a of the inverter device 13 in combination with the galvanic separation made by the opto-isolator module 15 between the inverter device 13 and the master control circuit 12 as envisaged by the present invention, ensures a complete electric isolation of the latter and the loads 7 from the inverter device 13.

The opto-isolator module 15 may comprise electronic component configured to transfer electric signals between two isolated circuits by using light. The opto-isolator module 15 may comprise the electro-optical devices such as: optocoupler components, electronic photocoupler components, electro-optical isolator components or similar.

According to an alternative embodiment (not illustrated), the opto-isolator module 15 instead of being arranged in the inverter device 13, may be arranged/integrated in the master control circuit 12.

According to an embodiment, the electronic processing unit 12a of the master control circuit 12 may be also configured to determine an overvoltage supply condition of the power supply lines 4 (and of the refrigerator appliance 1) based on the second value K2(V1).i.e. based on the first AC tension V1.

According to an advantageous embodiment of the present invention the electronic processing unit 12a of the master control circuit 12 may be further configured to determine an anomalous operation condition or a malfunction condition of the loads 7 and/or the loads 8 based on the determined main electric power.

According to an advantageous embodiment of the present invention the electronic processing unit 12a of the master control circuit 12 may be further configured to determine an anomalous operation condition or a malfunction condition of the inverter device 13 based on the determined main electric power.

The method of operation of the refrigerator appliance 1 envisages to implement the following steps: measuring by the current sensor 12b of the master control circuit 12 the first AC current I1 which flows across the AC power supply lines 4 and provides the first value K1(I1) indicative of the measured current I1 to the electronic processing unit 12a; measuring by the voltage measuring circuit 13b of the inverter device 13 the first AC voltage V1 on the AC power supply lines 4, providing by the opto-isolator module 15 the second value K2(V1) indicative of the first AC voltage V1 to the electronic processing unit 12a, determining preferably in real time by the electronic processing unit 12a, the third value K3(P1) indicative of the main electric power P1, based on the first value K1(I1) and the second value K2(V1).

As described above, the combined use of the voltage measure circuit of the inverter device to measure the first AC voltage and the galvanic separation between the inverter device and the master control circuit made by the opto-isolator module allows, on the one hand, to reduce the cost of the electronic system, and on the other hand, reducing the risk that the low voltage loads can be affected by the dangerous first AC voltage V1.

Clearly, changes may be made to the refrigerator appliance 1 without, however, departing from the scope of the present invention.

According to a possible different embodiment (not shown), the household appliance is a laundry washing machine. According to this embodiment, possible non-limitative examples of electric loads 8 may comprise: a motor for rotating a washer drum, a drain pump for draining washing liquid from a washing tub, a recirculation pump for recirculating washing liquid, and a heating resistor for heating washing liquid. According to this embodiment, possible non-limitative examples of low voltage electric loads 7 may comprise: control panel, and/or an illuminating circuit provided with light sources arranged inside the washing tube (i. e. LED sources).

According to a possible different embodiment (not shown), the household appliance is a laundry dryer machine. According to this embodiment, possible non-limitative examples of electric loads 8 may comprise: a motor for rotating a dryer drum, a fan for propelling drying air, a heating resistor for heating drying air, and a compressor for the heat pump circuit. In case the household appliance 1 is laundry dyer machine the electric loads 7 may comprise a control panel, and an illuminating circuit provided with light sources.

According to a possible different embodiment (not shown), the household appliance is an oven, According to this embodiment, possible non limitative examples of electric loads 8 may comprise a heating resistor for heating a cooking chamber, a microwave generator for generating microwaves radiation to be provided in the cooking chamber, and a fan for circulating air inside the cooking chamber. If the electric appliance is an oven, possible non-limitative examples of electric loads 7 may comprise a control panel and illuminating circuits.

## Claims

1. Household appliance comprising:
- first power supply lines (4) which are connectable to an AC power supply source (5) for receiving a main electric power (P1) from said AC power supply source (5) and for providing a first AC voltage (V1) and a first AC current (I1),
- at least a first load (8),
- at least a second load (7) operating by a second voltage (Vcc),
- a master control circuit (12) operating by said second voltage (Vcc), which is configured to generate control signals (SC) to selectively control said first load (8) and second load (7),
- an inverter device (13) which is electrically connected to said first power supply lines (4) for receiving said first AC voltage (V1),
said household appliance being **characterized in that**:
the second voltage (Vcc) is lower than said first AC voltage (V1);
the master control unit (12) further comprises a current measuring sensor (12b) configured to measure said first AC current (I1) and provide a first value (K1(I1) indicative of said first AC current (I1);
the inverter device (13) is connected to said master electronic control circuit (12) to receive said control signal (SC), and is configured to control the voltage supplied to said first load (8) based on said control signal (SC), said inverter device (13) further comprises a voltage measurement circuit (13b) configured to measure said first AC voltage (V1) and provide a second value (K2(V1)) indicative of said first AC voltage (V1); wherein
said inverter device (13) is configured to provide said second value (K2(V1) to said master control circuit (12) by opto-isolator electronic means (15),
said master control circuit (12) is configured to determine a third value (K3(P1)) indicative of said main electric power (P1) based on said first value (K1(I1)) and second value (K2(V1)).

2. Household appliance according to claim 1, wherein said master control circuit (12) is further configured to provide said control signal (SC) to said inverter device (13) by said opto-isolator electronic means (15).

3. Household appliance according to claims 1 or 2, wherein said opto-isolator electronic means (15) are comprised in said inverter device (13).

4. Household appliance according to claims 1 or 2, wherein said opto-isolator electronic means (15) are comprised in said master control circuit (12).

5. Household appliance according to any of the foregoing claims, wherein said opto-isolator electronic means (15) are structured to maintain said master control circuit (12) and said inverter device (13) galvanically insulated from each other.

6. Household appliance according to any of the foregoing claims, comprising a voltage transformer module (12b) which comprises input terminals connected to said power supply lines (4), and output terminals connected to said master control circuit (12), said voltage transformer module (12b) being configured to transform said first AC voltage (V1) in said second voltage (Vcc) to be supplied to said master control circuit (12) and or to said second loads (7) and is structured to maintain electrically isolated said master control circuit (12) and/or said second loads (7) from said power supply lines (4).

7. Household appliance according to any of the foregoing claims, wherein said current measuring sensor (12b) comprises a Hall Effect sensor.

8. Household appliance according to any of the foregoing claims, wherein said master control circuit (12) is configured to determine in real-time said main electric power (P1) based on said first value (K1(I1)) and second value (K2(V1)).

9. Household appliance according to any of the foregoing claims, wherein said master control circuit (12) is configured to determine an overvoltage supply condition of said first power supply lines (4) based on said second value (K2(V1)).

10. Household appliance according to any of the foregoing claims, wherein said master control circuit (12) is configured to determine an anomalous operation condition or a malfunction condition of said first loads (8) and/or second loads (7) based on said main electric power (P1).

11. Household appliance according to any of the foregoing claims, wherein said appliance is a refrigerator appliance and
said first load (8) comprises at least one among: a compressor unit, and a defrost heating resistor, and
said second load (7) comprises at least one among: a control panel and a illuminating circuit.

12. Household appliance according to any of the claims from 1 to 10, wherein said appliance is a laundry washing machine and
said first load (8) comprises at least one among: a drain pump, a recirculation pump a drum motor circuit and a heating resistor,
said second load (7) comprises at least one among: a control panel and a illuminating circuit.

13. Household appliance according to any of the claims from 1 to 10, wherein said appliance is an oven and
said first load (8) comprises at least one among: a heating resistor, a fan motor a microwave generator unit,
said second load (7) comprises at least one among: a control panel and a illuminating circuit.

14. Household appliance according to any of the claims from 1 to 10, wherein said appliance is a laundry dryer machine and
said first load (8) comprises at least one among: heating resistor, drum motor circuit, compressor unit, a motor fan,
said second load (7) comprises at least one among: a control panel and a illuminating circuit.

15. Method of operating of a household appliance, the household appliance comprising:
- first power supply lines (4) which are connectable to an AC power supply source (5) for receiving a main electric power (P1) from said AC power supply source (5) and for providing a first AC voltage (V1) and a first AC current (I1),
- at least a first load (8),
- at least a second load (7) operating by a second voltage (Vcc) lower than said first AC voltage (V1),
- a master control circuit (12) operating by said second voltage (Vcc), which is configured to generate control signals (SC) to selectively control said first load (8) and second load (7),
- an inverter device (13), which is electrically connected to said first power supply lines (4) for receiving said first AC voltage (V1) and said first AC current (I1) and to said master control circuit (12) to receive said control signal (SC), and is configured to control the voltage supplied to said first load (8) based on said control signal (SC),
the method being **characterized by**:
- measuring by a current sensor (12b) of the master control circuit (12) a first AC current (I1) and providing a first value (K1(I1)) indicative of said first AC current (I1),
- measuring by a voltage measurement circuit (13b) of said inverter device (13) said first AC voltage (V1) and providing a second value (K2(V1)) indicative of said first AC voltage (V1),
- providing said second value (K2(V1)) from said inverter device (13) to said master control circuit (12) by opto-isolator electronic means (15),
determining by said master control circuit (12) said main electric power (1) based on said first(K1(I1)) and second value (K2(V1)).

## Patentansprüche

1. Haushaltsgerät, das Folgendes umfasst:
- erste Stromversorgungsleitungen (4), die mit einer Wechselstromversorgungsquelle (5) zum Empfangen einer elektrischen Hauptleistung (P1) von der Wechselstromversorgungsquelle (5) und zum Bereitstellen einer ersten Wechselspannung (V1) und eines ersten Wechselstroms (I1) verbindbar sind,
- mindestens eine erste Last (8),
- mindestens eine zweite Last (7), die durch eine zweite Spannung (Vcc) arbeitet,
- eine Master-Steuerschaltung (12), die durch die zweite Spannung (Vcc) arbeitet und dazu ausgelegt ist, Steuersignale (SC) zum selektiven Steuern der ersten Last (8) und der zweiten Last (7) zu erzeugen,
- eine Wechselrichtervorrichtung (13), die zum Empfangen der ersten Wechselspannung (V1) elektrisch mit den ersten Stromversorgungsleitungen (4) verbunden ist, wobei das Haushaltsgerät **dadurch gekennzeichnet ist, dass**:
die zweite Spannung (Vcc) niedriger als die erste Wechselspannung (V1) ist;
die Master-Steuereinheit (12) ferner einen Strommesssensor (12b) umfasst, der dazu ausgelegt ist, den ersten Wechselstrom (I1) zu messen und einen ersten Wert (K1(I1)) bereitzustellen, der den ersten Wechselstrom (I1) angibt;
die Wechselrichtervorrichtung (13) mit der elektronischen Master-Steuerschaltung (12) verbunden ist, um das Steuersignal (SC) zu empfangen, und dazu ausgelegt ist, die der ersten Last (8) zugeführte Spannung basierend auf dem Steuersignal (SC) zu steuern, wobei die Wechselrichtervorrichtung (13) ferner eine Spannungsmessschaltung (13b) umfasst, die dazu ausgelegt ist, die erste Wechselspannung (V1) zu messen und einen zweiten Wert (K2(V1)) bereitzustellen, der die erste Wechselspannung (V1) angibt; wobei
die Wechselrichtervorrichtung (13) dazu ausgelegt ist, den zweiten Wert (K2(V1)) durch elektronische Optoisolatormittel (15) an die Master-Steuerschaltung (12) zu liefern,
die Master-Steuerschaltung (12) dazu ausgelegt ist, einen dritten Wert (K3(P1)), der die elektrische Hauptleistung (P1) angibt, basierend auf dem ersten Wert (K1(I1)) und dem zweiten Wert (K2(V1)) zu bestimmen.

2. Haushaltsgerät nach Anspruch 1, wobei die Master-Steuerschaltung (12) ferner dazu ausgelegt ist, das Steuersignal (SC) durch die elektronischen Optoisolatormittel (15) an die Wechselrichtervorrichtung (13) zu liefern.

3. Haushaltsgerät nach Anspruch 1 oder 2, wobei die elektronischen Optoisolatormittel (15) in der Wechselrichtervorrichtung (13) enthalten sind.

4. Haushaltsgerät nach Anspruch 1 oder 2, wobei die elektronischen Optoisolatormittel (15) in der Master-Steuerschaltung (12) enthalten sind.

5. Haushaltsgerät nach einem der vorhergehenden Ansprüche, wobei die elektronischen Optoisolatormittel (15) dahingehend strukturiert sind, die Master-Steuerschaltung (12) und die Wechselrichtervorrichtung (13) galvanisch voneinander getrennt zu halten.

6. Haushaltsgerät nach einem der vorhergehenden Ansprüche, umfassend ein Spannungstransformatormodul (12b), das Eingangsanschlüsse, die mit den Stromversorgungsleitungen (4) verbunden sind, und Ausgangsanschlüsse, die mit der Master-Steuerschaltung (12) verbunden sind, umfasst, wobei das Spannungstransformatormodul (12b) dazu ausgelegt ist, die erste Wechselspannung (V1) in die der Master-Steuerschaltung (12) und/oder den zweiten Lasten (7) zuzuführende zweite Spannung (Vcc) zu transformieren, und dahingehend strukturiert ist, die Master-Steuerschaltung (12) und/oder die zweiten Lasten (7) von den Stromversorgungsleitungen (4) elektrisch getrennt zu halten.

7. Haushaltsgerät nach einem der vorhergehenden Ansprüche, wobei der Strommesssensor (12b) einen Hall-Effekt-Sensor umfasst.

8. Haushaltsgerät nach einem der vorhergehenden Ansprüche, wobei die Master-Steuerschaltung (12) dazu ausgelegt ist, die elektrische Hauptleistung (P1) in Echtzeit basierend auf dem ersten Wert (K1(I1)) und dem zweiten Wert (K2(V1)) zu bestimmen.

9. Haushaltsgerät nach einem der vorhergehenden Ansprüche, wobei die Master-Steuerschaltung (12) dazu ausgelegt ist, einen Überspannungsversorgungszustand der ersten Stromversorgungsleitungen (4) basierend auf dem zweiten Wert (K2(V1)) zu bestimmen.

10. Haushaltsgerät nach einem der vorhergehenden Ansprüche, wobei die Master-Steuerschaltung (12) dazu ausgelegt ist, einen anomalen Betriebszustand oder einen Fehlfunktionszustand der ersten Lasten (8) und/oder der zweiten Lasten (7) basierend auf der elektrischen Hauptleistung (P1) zu bestimmen.

11. Haushaltsgerät nach einem der vorhergehenden Ansprüche, wobei das Gerät ein Kühlgerät ist und
die erste Last (8) eine Verdichtereinheit und/oder einen Abtauheizwiderstand umfasst und
die zweite Last (7) ein Bedienfeld und/oder eine Beleuchtungsschaltung umfasst.

12. Haushaltsgerät nach einem der Ansprüche 1 bis 10, wobei das Gerät eine Waschmaschine ist und
die erste Last (8) eine Ablaufpumpe und/oder eine Umwälzpumpe und/oder eine Trommelmotorschaltung und/oder einen Heizwiderstand umfasst,
die zweite Last (7) ein Bedienfeld und/oder eine Beleuchtungsschaltung umfasst.

13. Haushaltsgerät nach einem der Ansprüche 1 bis 10, wobei das Gerät ein Ofen ist und
die erste Last (8) einen Heizwiderstand und/oder einen Lüftermotor und/oder eine Mikrowellengeneratoreinheit umfasst,
die zweite Last (7) ein Bedienfeld und/oder eine Beleuchtungsschaltung umfasst.

14. Haushaltsgerät nach einem der Ansprüche 1 bis 10, wobei das Gerät eine Wäschetrocknermaschine ist und
die erste Last (8) einen Heizwiderstand und/oder eine Trommelmotorschaltung und/oder eine Verdichtereinheit und/oder einen Motorlüfter umfasst,
die zweite Last (7) ein Bedienfeld und/oder eine Beleuchtungsschaltung umfasst.

15. Verfahren zum Betreiben eines Haushaltsgeräts, wobei das Haushaltsgerät Folgendes umfasst:
- erste Stromversorgungsleitungen (4), die mit einer Wechselstromversorgungsquelle (5) zum Empfangen einer elektrischen Hauptleistung (P1) von der Wechselstromversorgungsquelle (5) und zum Bereitstellen einer ersten Wechselspannung (V1) und eines ersten Wechselstroms (I1) verbindbar sind,
- mindestens eine erste Last (8),
- mindestens eine zweite Last (7), die durch eine zweite Spannung (Vcc) arbeitet, die niedriger als die erste Wechselspannung (V1) ist,
- eine Master-Steuerschaltung (12), die durch die zweite Spannung (Vcc) arbeitet und dazu ausgelegt ist, Steuersignale (SC) zum selektiven Steuern der ersten Last (8) und der zweiten Last (7) zu erzeugen,
- eine Wechselrichtervorrichtung (13), die zum Empfangen der ersten Wechselspannung (V1) und des ersten Wechselstroms (I1) elektrisch mit den ersten Stromversorgungsleitungen (4) verbunden ist und zum Empfangen des Steuersignals (SC) elektrisch mit der Master-Steuerschaltung (12) verbunden ist und dazu ausgelegt ist, die der ersten Last (8) zugeführte Spannung basierend auf dem Steuersignal (SC) zu steuern,
wobei das Verfahren durch Folgendes gekennzeichnet ist:
- Messen eines ersten Wechselstroms (I1) durch einen Stromsensor (12b) der Master-Steuerschaltung (12) und Bereitstellen eines ersten Werts (K1(I1)), der den ersten Wechselstrom (I1) angibt,
- Messen der ersten Wechselspannung (V1) durch eine Spannungsmessschaltung (13b) der Wechselrichtervorrichtung (13) und Bereitstellen eines zweiten Werts (K2(V1)), der die erste Wechselspannung (V1) angibt,
- Liefern des zweiten Werts (K2(V1)) von der Wechselrichtervorrichtung (13) an die Master-Steuerschaltung (12) durch elektronische Optoisolatormittel (15),
Bestimmen der elektrischen Hauptleistung (1) durch die Master-Steuerschaltung (12) basierend auf dem ersten (K1(I1)) und zweiten Wert (K2(V1)).

## Revendications

1. Appareil ménager comprenant :
- des premières lignes d'alimentation électrique (4) qui peuvent être connectées à une source d'alimentation en courant alternatif (5) pour recevoir une puissance électrique principale (P1) en provenance de ladite source d'alimentation en courant alternatif (5) et pour fournir une première tension alternative (V1) et un premier courant alternatif (I1),
- au moins une première charge (8),
- au moins une deuxième charge (7) fonctionnant sous une deuxième tension (Vcc),
- un circuit de commande maître (12) fonctionnant sous ladite deuxième tension (Vcc), qui est configuré pour générer des signaux de commande (SC) pour commander de manière sélective lesdites première charge (8) et deuxième charge (7),
- un dispositif inverseur (13) qui est connecté électriquement auxdites premières lignes d'alimentation électrique (4) pour recevoir ladite première tension alternative (V1),
ledit appareil ménagé étant **caractérisé en ce que** :
la deuxième tension (Vcc) est inférieur à ladite première tension alternative (V1) ;
l'unité de commande maîtresse (12) comprend en outre un capteur de mesure de courant (12b) configuré pour mesurer ledit premier courant alternatif (I1) et fournir une première valeur (K1(I1)) indicative dudit premier courant alternatif (I1) ;
le dispositif inverseur (13) est connecté audit circuit de commande électronique maître (12) pour recevoir ledit signal de commande (SC), et est configuré pour commander la tension fournie à ladite première charge (8) en fonction dudit signal de commande (SC), ledit dispositif inverseur (13) comprend en outre un circuit de mesure de tension (13b) configuré pour mesurer ladite première tension alternative (V1) et fournir une deuxième valeur (K2(V1)) indicative de ladite première tension alternative (V1) ; où
ledit dispositif inverseur (13) est configuré pour fournir ladite deuxième valeur (K2(V1)) audit circuit de commande maître (12) par l'intermédiaire de moyens électroniques opto-isolateurs (15),
ledit circuit de commande maître (12) est configuré pour déterminer une troisième valeur (K3(P1)) indicative de ladite puissance électrique principale (P1) en fonction desdites première valeur (K1(I1)) et deuxième valeur (K2(V1)).

2. Appareil ménager selon la revendication 1, dans lequel ledit circuit de commande maître (12) est en outre configuré pour fournir ledit signal de commande (SC) audit dispositif inverseur (13) par l'intermédiaire desdits moyens électroniques opto-isolateurs (15).

3. Appareil ménager selon la revendication 1 ou 2, dans lequel lesdits moyens électroniques opto-isolateurs (15) sont inclus dans ledit dispositif inverseur (13).

4. Appareil ménager selon la revendication 1 ou 2, dans lequel lesdits moyens électroniques opto-isolateurs (15) sont inclus dans ledit circuit de commande maître (12).

5. Appareil ménager selon l'une quelconque des revendications précédentes, dans lequel lesdits moyens électroniques opto-isolateurs (15) sont structurés pour maintenir ledit circuit de commande maître (12) et ledit dispositif inverseur (13) galvaniquement isolés l'un de l'autre.

6. Appareil ménager selon l'une quelconque des revendications précédentes, comprenant un module transformateur de tension (12b) qui comprend des bornes d'entrée connectées auxdites lignes d'alimentation électrique (4), et des bornes de sortie connectées audit circuit de commande maître (12), ledit module transformateur de tension (12b) étant configuré pour transformer ladite première tension alternative (V1) en ladite deuxième tension (Vcc) pour la fournir audit circuit de commande maître (12) et/ou auxdites deuxièmes charges (7) et étant structuré pour maintenir ledit circuit de commande maître (12) et/ou lesdites deuxième charges (7) électriquement isolées desdites lignes d'alimentation électriques (4).

7. Appareil ménager selon l'une quelconque des revendications précédentes, dans lequel ledit capteur de mesure de courant (12b) comprend un capteur à Effet Hall.

8. Appareil ménager selon l'une quelconque des revendications précédentes, dans lequel ledit circuit de commande maître (12) est configuré pour déterminer la puissance électrique principale (P1) en temps réel en fonction desdites première valeur (K1(I1)) et deuxième valeur (K2(V1)).

9. Appareil ménager selon l'une quelconque des revendications précédentes, dans lequel ledit circuit de commande maître (12) est configuré pour déterminer une condition d'alimentation en surtension desdites premières lignes d'alimentation électrique (4) en fonction de ladite deuxième valeur (K2(V1)).

10. Appareil ménager selon l'une quelconque des revendications précédentes, dans lequel ledit circuit de commande maître (12) est configuré pour déterminer une condition de fonctionnement anormale ou une condition de dysfonctionnement desdites premières charges (8) et/ou deuxièmes charges (7) en fonction de ladite puissance électrique principale (P1).

11. Appareil ménager selon l'une quelconque des revendications précédentes, dans lequel ledit appareil est un réfrigérateur et
ladite première charge (8) comprend au moins l'un des éléments suivants : un groupe compresseur, et une résistance chauffante de dégivrage, et
ladite deuxième charge (7) comprend au moins l'un des éléments suivants : un panneau de commande et un circuit d'éclairage.

12. Appareil ménager selon l'une quelconque des revendications 1 à 10, dans lequel ledit appareil est une machine à laver le linge et
ladite première charge (8) comprend au moins l'un des éléments suivants : une pompe de vidange, une pompe de recirculation, un circuit de moteur de tambour et une résistance chauffante,
ladite deuxième charge (7) comprend au moins l'un des éléments suivants : un panneau de commande et un circuit d'éclairage.

13. Appareil ménager selon l'une quelconque des revendications 1 à 10, dans lequel ledit appareil est un four et
ladite première charge (8) comprend au moins l'un des éléments suivants : une résistance chauffante, un moteur de ventilateur, une unité génératrice de micro-ondes,
ladite deuxième charge (7) comprend au moins l'un des éléments suivants : un panneau de commande et un circuit d'éclairage.

14. Appareil ménager selon l'une quelconque des revendications 1 à 10, dans lequel ledit appareil est une machine à laver le linge et
ladite première charge (8) comprend au moins l'un des éléments suivants : une résistance chauffant, un circuit de moteur de tambour, un groupe compresseur, un ventilateur de moteur,
ladite deuxième charge (7) comprend au moins l'un des éléments suivants : un panneau de commande et un circuit d'éclairage.

15. Procédé de fonctionnement d'un appareil ménager, l'appareil ménager comprenant :
- des premières lignes d'alimentation électrique (4) qui peuvent être connectées à une source d'alimentation en courant alternatif (5) pour recevoir une puissance électrique principale (P1) en provenance de ladite source d'alimentation en courant alternatif (5) et pour fournir une première tension alternative (V1) et un premier courant alternatif (I1),
- au moins une première charge (8),
- au moins une deuxième charge (7) fonctionnant sous une deuxième tension (Vcc), inférieure à ladite première tension alternative (V1),
- un circuit de commande maître (12) fonctionnant sous ladite deuxième tension (Vcc), qui est configuré pour générer des signaux de commande (SC) pour commander de manière sélective lesdites première charge (8) et deuxième charge (7),
- un dispositif inverseur (13) qui est connecté électriquement auxdites premières lignes d'alimentation électrique (4) pour recevoir ladite première tension alternative (V1) et ledit premier courant alternatif (I1) et audit circuit de commande maître (12) pour recevoir ledit signal de commande (SC), et configuré pour commander la tension fournie à ladite première charge (8) en fonction dudit signal de commande (SC),
le procédé étant **caractérisé par** :
- la mesure par un premier capteur de courant (12b) du circuit de commande maître (12) d'un premier courant alternatif (I1) et la fourniture d'une première valeur (K1(I1)) indicative dudit premier courant alternatif (I1),
- la mesure par un circuit de mesure de tension (13b) dudit dispositif inverseur (13) de ladite première tension alternative (V1) et la fourniture d'une deuxième valeur (K2(V1)) indicative de ladite première tension alternative (V1),
- la fourniture de ladite deuxième valeur (K2(V1)) par ledit dispositif inverseur (13) audit circuit de commande maître (12) par l'intermédiaire de moyens électroniques opto-isolateurs (15),
la détermination par ledit circuit de commande maître (12) de ladite puissance électrique principale (1) en fonction desdites première valeur (K1(I1)) et deuxième valeur (K2(V1)).
